# EUROPEAN PATENT APPLICATION

(11) **EP 4 632 117 A1**
(43) Date of publication of application: **15.10.2025**
(21) Application number: 24169109.6
(22) Date of filing: 09.04.2024
(51) Int. Cl.: C30B 23/02, C30B 29/36, C30B 29/40

(54) **MULTILAYER SEED FOR SINGLE-CRYSTAL GROWTH, METHOD OF PRODUCING A MULTILAYER SEED, USE OF THE MULTILAYER SEED IN A PVT PROCESS FOR GROWING A SINGLE-CRYSTAL AND PVT PROCESS USING THE SAME**

(71) Applicant: SiCrystal GmbH, 90411 Nürnberg (DE)
(72) Inventor: Ecker, Bernhard, 90411 Nürnberg (DE); Klietz, Wenzel, 90411 Nürnberg (DE); Müller, Ralf, 90411 Nürnberg (DE); Schuh, Philipp, 90411 Nürnberg (DE); Stockmeier, Matthias, 90411 Nürnberg (DE); Vogel, Michael, 90411 Nürnberg (DE)
(74) Representative: Grünecker Patent- und Rechtsanwälte PartG mbB

(57) **Abstract**

The present invention provides a multilayer seed which is designed such as to offer a virtually unstressed surface onto which a single-crystal can grow without the negative impact of the internal stress carried by monocrystalline seeds, in particular at the high temperatures conventionally used in sublimation processes. The multilayer seed for growing a single-crystal comprise at least two seed layers, wherein each of the at least two seed layers is a monocrystalline layer characterized by one or more parameters associated with a respective degree of internal stress. The one or more parameters are selected such that the at least two seed layers are adapted to counter-act the respective internal stresses from each other.

## Description

### TECHNICAL FIELD OF THE INVENTION

The present invention relates to a multilayer seed designed with a combination of multiple, monocrystalline layers for reducing or eliminating the negative impact of internal stress of monocrystalline seeds on crystal growth, a method of producing the multilayer seed, use of the multilayer seed and a PVT process for growing a single-crystal with the multilayer seed.

### BACKGROUND OF THE INVENTION

Semiconductor substrates are commonly used for the production of electronic components. In particular, substrates of silicon carbide (SiC) are at the base of production of power electronic components, e.g. in the automotive and green energy industries. Generally, such electronic components are made from thin monocrystalline layers of semiconductor material (e.g. SiC, GaN) which are deposited onto SiC substrates using epitaxial processes. The properties of the deposited monocrystalline layers, and consequently, of the electronic components produced therefrom, therefore depends decisively on the properties and quality of the underlying SiC substrates.

SiC substrates are generally produced from a SiC single-crystal boule, e.g. by cutting wafers from the single-crystal boule using thread-saws or similar separation processes. These wafers are then further processed, e.g. in multiple polishing steps to obtain substrates with polished surfaces suitable for growing single-crystals thereon. The quality of the SiC substrates nevertheless still depends on the crystalline quality of the SiC single-crystal boule (also referred to hereinafter as bulk SiC single-crystal) from which they are produced.

As a standard, bulk SiC single-crystals employed in the production of SiC substrates are grown using physical vapor transport (PVT) processes. The basic principle of a PVT process lies in sublimating a suitable source material into a gas phase and depositing the species (e.g. SiC, Si₂C, SiC₂) present in the gas phase, and from which the single-crystal will grow, onto a monocrystalline seed, which is generally a wafer of monocrystalline material cut from a bulk single-crystal. The quality of the seed is extremely important in order to obtain a bulk single-crystal with a low density of defects for producing high-quality SiC substrates.

Thus, the increasing demand for SiC substrates with a high-quality suitable for the production of electronic components also requires high-quality seeds so as to grow bulk SiC single-crystals of the highest quality possible.

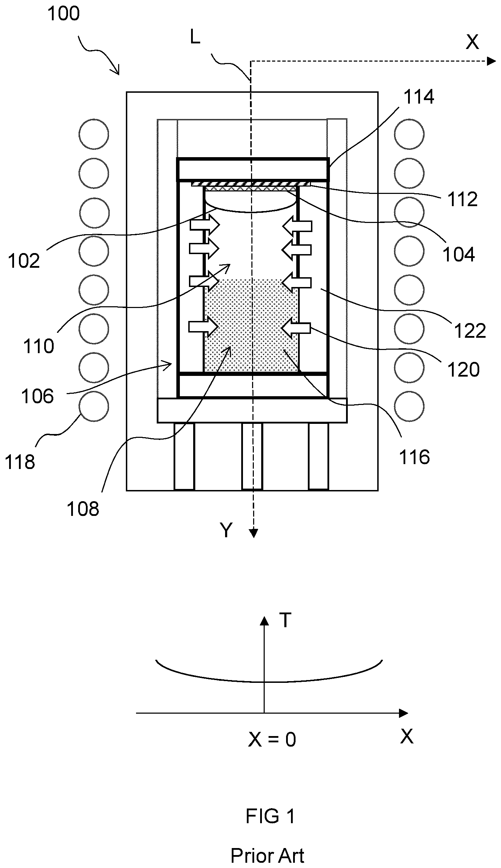

Generally, seeds are themselves produced from single-crystals which are grown using the same or sublimation processes similar to those employed for growing the bulk single-crystals from which semiconductor substrates are made. However, the inventors realized that the use of a single, monocrystalline seed, as it is commonly used in conventional PVT processes, leads to an unexpected low quality of the grown SiC single-crystal. This is caused by the intrinsic tensions present in the monocrystalline seed itself, e.g. thermally induced stresses, that affect the growing SiC single-crystal, as it will now be described with reference to Figs. 1-3.

Fig. 1 depicts a conventional growth arrangement 100 for growing a bulk single-crystal 102 by sublimation growth onto a single, monocrystalline seed 104. The growth arrangement 100 includes a crucible 106 in which crystal growth takes place and which includes, e.g. a source material region 108 and a crystal growth region 110, in which the seed 104 is arranged. The seed 104 is attached to a seed holder 112, e.g. provided on a crucible lid 114, by a fixation layer or by clamping (not shown) and is oriented with the surface for crystal growth towards the source material region 108 which is filled with a suitable source material 116, e.g. SiC in powdered form. During the growth process, the source material 116 is sublimated by controlled heat generated with a heating system surrounding the crucible 106, such as a thermal induction coil 118 or alternatively, by resistance heating means. The species sublimated into the gas phase (e.g. SiC, Si₂C, SiC₂) are then transported towards the monocrystalline seed 104 by the thermal gradients established within the crucible 106 in a controlled manner and the bulk single-crystal 102 grows by deposition of the species onto the growth surface of the seed crystal 104. The bulk single-crystal 102 may be used for producing one or more wafers of monocrystalline seeds (i.e. seed crystals) therefrom. An exemplary PVT process is described in US 8,865,324 B2.

For the growth of SiC single-crystals using PVT processes, the temperature gradients in the axial and radial directions are set very precisely in order to produce high-quality single-crystals. The axial temperature gradient, which is established in the axial direction from the SiC source material 116 towards the seed 104 (i.e. the direction of the midlongitudinal axis L in Fig. 1) determines the growth rate of the single-crystal. The temperature gradient in the radial direction, i.e. in the direction transverse to the growth direction L, is set so as to form a convex single-crystal, i.e. a single-crystal boule having an uppermost surface with a convex curvature in the growth direction. The fat arrows in Fig. 1 exemplify directions of heat flow for establishing a convex radial gradient inside the crystal growth area 110 of the crucible 106 for forming the convex single-crystal 102. The convexity of the single-crystal 102 prevents in-growth of defects at the single-crystal edges, which may occur due to the unavoidable contact of the growing single-crystal 102 with the crucible walls 122. However, as the single-crystal convexity is associated with the formation of intrinsic stresses, it also leads to an increase of dislocation densities as well as of the geometric values of bow and warp of the monocrystalline seeds produced from convex single-crystals.

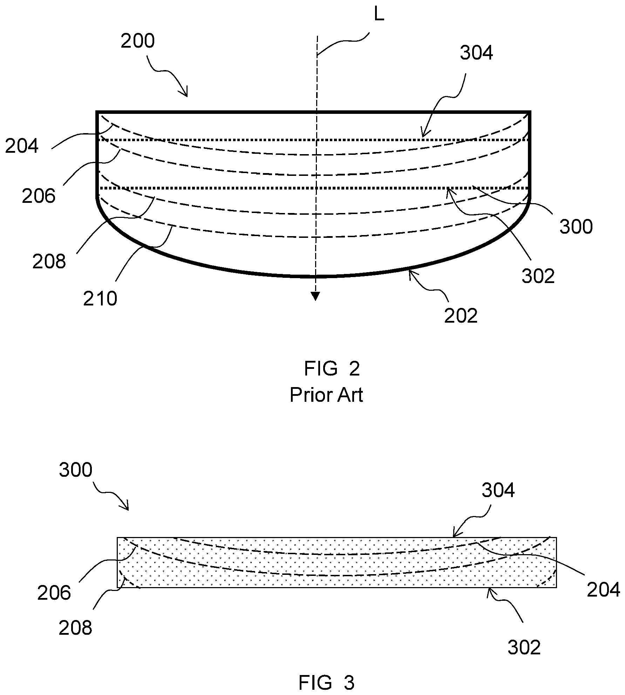

Fig. 2 illustrates an example of a convex SiC single-crystal 200 obtained by a conventional sublimation process (such as described with reference to Fig. 1). The bulk SiC single-crystal 200 has a convex uppermost surface 202 with several intrinsic stress regions (depicted with dashed lines 204, 206, 208, 210) that were induced by the thermal gradients during the crystal growth and which tend to follow the convexity of the uppermost surface 202. The monocrystalline seeds or wafers produced from the bulk SiC single-crystal 200 will thus carry part of the intrinsic, stress regions 204, 206, 208, 210 present in the SiC single-crystal 200. For instance, in case of a SiC monocrystalline seed 300 produced from the region depicted by dotted lines in Fig. 2, the intrinsic, stress regions 204, 206, 208 are not even evenly distributed in the SiC monocrystalline seed 300. Namely, the carbon-terminated surface 302 (C-face) and the silicon-terminated surface 304 (Si-face) of the SiC monocrystalline seed 300 are intersected differently by the intrinsic stress regions 206, 208, 210. This affects the overall response of the SiC monocrystalline seed 300 to thermally induced stresses at the high-temperatures used during sublimation growth.

Furthermore, the flatness of the monocrystalline seed 300 may also be affected by the convexity of the intrinsic stress regions 204, 206, 208, depending on the seed thickness and the temperatures at which it is submitted during a PVT growth process. For instance, the SiC monocrystalline seed 300 may bend according to the predominant curvature of the intrinsic, stress regions 204, 206, 208, thus causing the formation of additional internal stresses and dislocations on the bulk SiC single-crystal growing thereon. This leads to an increased density of dislocations (in particular stress-induced basal plane dislocations) in the SiC substrates produced from the resultant bulk SiC single-crystal.

In overall, even when using the most favorable thermal gradients, the monocrystalline seeds produced from such single-crystals still do not have the adequate quality for growing bulk single-crystals with a high-quality that meets the increasing demands of the semiconductor substrate industry.

Until now, the effects of the thermally and mechanically induced stresses during growth and/or processing of bulk single-crystals on the reduced quality of the produced monocrystalline seeds has not been adequately addressed.

EP 1 200 651 B1 describes a crystal growth arrangement with a lateral framing of the seed that is intended to enable the growth of high-quality single-crystals by means of the special fixture of the seed. However, this arrangement cannot fully eliminate the effects of internal stresses during crystal growth. In addition, it uses metallic compounds in the vicinity of the seed, which may lead to contamination of the growing single-crystal. Generally, contaminated single-crystal have to be discarded as waste.

Thus, there is still a need for a solution to the problem of how to reduce or even eliminate the negative impact of the internal stresses of monocrystalline seeds, which are intrinsic to the seed, on the quality of the bulk single-crystals grown thereon, and ultimately, to improve the quality of the substrates produced therefrom.

### SUMMARY OF THE INVENTION

It is accordingly an object of the present invention to provide a multilayer seed, a method of producing the multilayer seed, and a PVT process for growing a bulk single-crystal using the same, that eliminate or at least mitigate the above-mentioned disadvantages of the prior art monocrystalline seeds and growth methods.

This object is solved by the subject matter of the independent claims. Particular embodiments of the present invention are the subject matter of the dependent claims.

A concept of the solution of the present invention lies in increasing the quality of the single-crystals grown with sublimation processes by providing a multilayer seed which is designed such as to offer a virtually unstressed surface onto which a single-crystal can grow without the negative impact of the internal stress carried by monocrystalline seeds, in particular at the high temperatures conventionally used in sublimation processes.

Thus, the present invention allows to overcome the problems described above when using a monocrystalline seed by providing a multilayer seed which behaves like a virtually unstressed seed.

Accordingly, the present invention provides a multilayer seed for growing a single-crystal, comprising at least two seed layers, wherein each of the at least two seed layers is a monocrystalline layer characterized by one or more parameters associated with a respective degree of internal stress, said one or more parameters are selected such that the at least two seed layers are adapted to counter-act the respective internal stresses from each other.

According to a further development, each of the at least two seed layers is a monocrystalline layer, and/or said one or more parameters includes one or more of a bow value, a warp value, a total thickness variation value, a thickness, and a doping content of the respective seed layer.

According to a further development, the at least two seed layers includes an uppermost seed layer that provides a growth surface adapted to grow the single-crystal thereon; and the at least two seed layers are arranged adjacent to each other along an axial direction which is transverse to said growth surface. The axial direction is the direction intended for growing a single-crystal onto the multilayer seed.

According to a further development, each of the at least two seed layers is a monocrystalline layer terminated by a face of a first type, which is characterized by a first crystalline lattice plane, and an opposed face of a second type, which is characterized by a second lattice plane, and adjacent seed layers are arranged with the same face type turned towards each other so as to counter-act their respective internal stresses.

According to a further development, the at least two seed layers are SiC monocrystalline layers, the first type face is a C-face and the second type face is a Si-face, and the uppermost seed layer of the at least two seed layers is arranged with a C-face as the terminating surface for crystal growth.

According to a further development, the at least two seed layers are selected based on their respective bow values so as to compensate the intrinsic stress of the adjacent seed layers and so that the multilayer seed is characterized by a bow value between -50µm and +50µm, or between -30µm and +30µm, or between -20µm and +20µm.

In a further development, the at least two seed layers are selected based on their respective warp values so as to compensate the intrinsic stress of the adjacent seed layers and so that the multilayer seed is characterized by a warp value smaller than 50µm, or smaller than 30µm, or smaller than 20µm.

According to a further development, the at least two seed layers are selected based on their respective total thickness variation values so as to compensate the intrinsic stress of the adjacent seed layers and so that the multilayer seed is characterized by a total thickness variation value smaller than 50µm, or smaller than 30µm, or smaller than 20µm.

According to a further development, a growth seed layer of the at least two seed layers has a minimum thickness of 0.5 mm and a maximum thickness of 2.0 mm, and the at least two seed layers, other than the growth seed layer, have respective thicknesses between 350µm and 3mm.

According to a further development, the at least two seed layers are comprised of:
a maximum of four monocrystalline seed layers; and/or
one or more monocrystalline seed layers with different doping contents; and/or
one or more monocrystalline seed layers made of any of the semiconductor materials selected from Si, SiC, AIN, GaN, AlGaN, AllnN and InN; and/or
an homostructure of monocrystalline seed layers made of one of the semiconductor materials selected from Si, SiC, AIN, GaN, AlGaN, AllnN and InN; and/or
an heterostructure of monocrystalline seed layers in a combination of semiconductor materials selected from Si, SiC, AIN, GaN, AlGaN, AllnN and InN.

According to a further development, the at least two seed layers include one or more monocrystalline seed layers having different levels of sub-surface damage which is obtained by processing the seed layers with at least one of sawing, grinding, and polishing; and/or the at least two seed layers are bonded together with a bonding layer between each pair of adjacent seed layers, the bonding layer being formed by adhesive means or sintering.

According to a further development, the uppermost seed layer for crystal growth is oriented with the [0001] crystalline axis tilted out of an axial direction by a tilt angle which is between 0° and 8°, or between 2° and 6°.

The present invention also provides a method of producing the multilayer seed according to the invention, the method comprising:
selecting at least two seed crystals for the at least two seed layers of the multilayer seed;
arranging the at least two seed crystals adjacent to each other along an axial direction which is a direction for growing a single-crystal on the multilayer seed; and
forming a bonding layer between each pair of adjacent seed layers;
wherein each of the at least two seed crystals is selected based on one or more parameters associated with a respective degree of internal stress such as to counter-act the respective internal stresses from each other.

The present invention also includes use of a multilayer seed according to the present invention on a sublimation process for growing a semiconductor single-crystal.

The present invention also provides a physical vapor transport (PVT) method for producing at least one SiC single-crystal, comprising: arranging, inside a PVT growth crucible, at least one seed and a source material adapted to grow a SiC single-crystal; introducing the growth crucible into an inductively-heated or resistance-heated reactor of a PVT system; and controlling the temperature gradients established inside the growth crucible to grow the at least one SiC single-crystal onto the at least one seed; characterized in that the at least one seed is a multilayer seed according to the present invention.

According to a further development, the temperature gradients are controlled so as to achieve a growth temperature range from 2000°C to 2500°C, or from 2100°C to 2400°C inside the PVT growth crucible.

The accompanying drawings are incorporated into and form a part of the specification to illustrate several embodiments of the present invention. These drawings, together with the description serve to explain the principles of the invention. The drawings are merely for the purpose of illustrating preferred and/or alternative examples of how the invention can be made and/or used, and therefore, are not to be construed as limiting the invention to only the illustrated and described embodiments. Furthermore, several aspects of the embodiments may form, individually or in different combinations, solutions according to the present invention. The following described embodiments thus can be considered either alone or in an arbitrary combination thereof.

### BRIEF DESCRIPTION OF THE FIGURES

Further features and advantages will become apparent from the following more particular description of the various embodiments of the invention, as illustrated in the accompanying drawings, in which like references refer to like elements, and wherein:
- **Fig. 1**: is a diagrammatic, sectional view of a conventional PVT growth arrangement for producing a semiconductor single-crystal by sublimation growth over a seed made of a single, monocrystalline layer; the lower diagram depicts a profile of the radial temperature gradient with distance (X-axis) from a longitudinal mid-axis L (Y-axis) of the PVT growth arrangement for growing a convex single-crystal;
- **Fig. 2**: is a diagrammatic, cross-sectional view of a conventional, convex single-crystal with frozen induced stresses (depicted in dashed lines) that are formed due to the thermal gradients established during crystal growth. A position of a monocrystalline seed to be produced from the bulk single-crystal is depicted in dotted lines;
- **Fig. 3**: is a diagrammatic, cross-sectional view of a monocrystalline seed produced from the bulk single-crystal shown in Fig. 2; the dashed lines depict intrinsic stresses regions of the monocrystalline seed that were transferred from the bulk single-crystal;
- **Fig. 4**: is a schematic, cross-sectional view of an exemplary embodiment of a multilayer seed according to the present invention;
- **Fig. 5**: is a schematic, cross-sectional view of a further exemplary embodiment of a multilayer seed according to the present invention;
- **Fig. 6**: is a schematic, cross-sectional view of a further exemplary embodiment of a multilayer seed according to the present invention; and
- **Fig. 7**: is a schematic, cross-sectional view of a further exemplary embodiment of a multilayer seed according to the present invention; and
- **Fig. 8**: shows a comparison in form of flowcharts of processes for producing SiC substrates from SiC single-crystals grown with a conventional monocrystalline seed vs. a multilayer seed according to the present invention.

### DETAILED DESCRIPTION OF THE INVENTION

A concept of the present invention lies in increasing the quality of the bulk single-crystals obtained with sublimation processes, and thus, of the substrates made therefrom, by providing a specially designed seed which offers a surface for crystal growth that is virtually unstressed at the temperatures conventionally used in sublimation processes. As a result, a bulk single-crystal can be grown without the negative effects of the intrinsic stresses posed by the use of a seed which is produced from a single wafer or slice of a single-crystal (hereinafter referred to as a monocrystalline seed layer or simply seed layer), such as the monocrystalline seed 300 discussed above with reference to Figs. 2 and 3.

This is achieved by providing a multilayer seed that is comprised of a combination of monocrystalline seed layers (i.e. at least two seed layers) which are arranged in a stacked manner (i.e. stacked one on top of another) along a direction for crystal growth and firmly bonded together so as to cancel out the respective internal stresses from each other. In particular, the combination of monocrystalline seed layers is selected so as to equalize the effect of internal stresses at the temperature ranges conventionally used in sublimation processes, e.g. approximately from 2000°C to 2400°C, at least in the uppermost seed layer onto which the bulk single-crystal grows (hereinafter referred to as the growth seed layer).

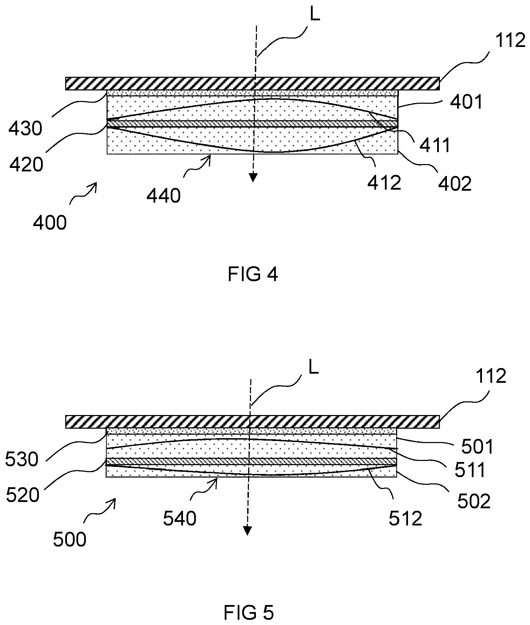

As it will be explained in the following with reference to Figs. 4 to 7, multilayer seeds composed of different combinations of monocrystalline seed layers may be envisaged (e.g. in number, thickness and orientation) depending on the degree of internal stress of the individual seed layers such as to achieve a multilayer seed with an uppermost seed layer that is virtually stress-free during crystal growth,.

Fig. 4 illustrates a multilayer seed 400 comprising a plurality of monocrystalline SiC seed layers, i.e. at least two seed layers which include a first seed layer 401 and a second seed layer 402. Each monocrystalline seed layer 401, 402 corresponds to a slice or wafer of monocrystalline material produced from a bulk single-crystal, such as the monocrystalline layer 300 described above with reference to Figs. 2 and 3. The plurality of monocrystalline seed layers 401, 402 is preferably made from the same semiconductor material, e.g. from the same bulk single-crystal, or from different bulk single-crystals. Each of the individual seed layers 401, 402 is characterized by respective internal stress regions 411, 412 correspondent to the stressed regions of the bulk single-crystals from which each individual seed layer 401, 402 is produced.

The first and second seed layers 401, 402 are preferably disk-like slices, which are arranged adjacent to each other along a longitudinal mid-axis L transverse to their disk-like surface, i.e. forming a multilayered stack in the intended direction for crystal growth onto the multilayer seed 400. In addition, the first and second seed layers 401, 402 are firmly bonded together by a bonding layer 420. The bonding layer 420 provides a temperature-stable bonding at the temperatures ranges used in sublimation growth, e.g. up to approx. 2000°C to 2400°C and may be made by gluing or sintering. In the case of gluing, organic compounds such as special phenolic resins, Novolake, can be used as adhesives. In the case of a sintering connection, fine silicon powder, for example, can be used as a sintering aid. The first seed layer 401 may be fixed to the seed holder 112 by a fixation layer 430 made by gluing or sintering, namely, using the same or other compounds than those used for the bonding layer 420. Alternatively, the seed holder 112 may be fixed to the first seed layer 401 by clamping.

In order to achieve a multilayer seed 400 with a growth surface that will be stress-free at the crystal growth temperatures, the first and second seed layers 401, 402 are stacked upon each other and oriented based on their respective intrinsic stresses so that the effects produced by the intrinsic stressed region 411 carried by the first seed layer 401 counter-act the effects produced by the intrinsic stress of the uppermost seed layer, i.e. the second seed layer 402 in the configuration of Fig. 4, at least at the growth temperatures.

For instance, the internal stress of each of the individual SiC seed layers 401, 402 forming the multilayer seed 400 may be compensated, for example, by orienting the first and second seed layers 401, 402 in the multilayered stack such that the carbon-terminated surface (C-face) of one of the SiC seed layers (e.g. the first seed layer 401) is turned towards the C-face of the adjacent, neighboring layer (e.g. the second seed layer 402). Alternatively, adjacent seed layers may be turned with the respective silicon-terminated surfaces (Si-face) facing each other. Such relative orientation between the adjacent SiC seed layers 401, 402 that form the multilayer seed 400 can be achieved by first preparing a SiC seed layer from a bulk SiC single-crystal (e.g. the second seed layer 401) and then rotating the SiC seed layer by 180° in relation to the growth direction of the original single-crystal. The rotated SiC seed layer is thus connected to a another, non-rotated SiC seed layer (e.g. the second seed layer 402).

In case the multilayer seed is intended for growing a 4H-SiC single-crystal, the free surface for crystal growth, i.e. the uppermost surface of the multilayer seed should be carbon-terminated. In this case, the uppermost SiC seed layer of the multilayer seed should be oriented so that its C-face corresponds to the free face. This specific orientation of the uppermost seed layer will determine the orientation of the underlying, lower seed layers with regard to their intrinsic stresses so as to achieve an effective compensation between adjacent seed layers. For instance, as illustrated in Fig. 3, according to the relation between the convex curvature of the intrinsic stress regions 204, 206, 208 carried by the individual seed layer 300 obtained from the convex SiC single-crystal 200 and relative positioning of the C-terminated surface 302 and the Si-terminated surface 304, an effective compensation of the internal stresses between adjacent layers in the multilayer seed may be achieved by alternating the curvature sign of the stress regions carried by each individual seed layer. For instance, in the multilayer seed 400 shown in Fig. 4, the uppermost, second seed layer 402 is oriented with the C-terminated surface 440 as the free, growth surface of the multilayer seed 400. As a result, as the Si-terminated surface of the second seed layer 402 is turned towards the underlying first seed layer 401, the first seed layer 401 is oriented to counter-act the internal stresses of the second seed layer 402, i.e. the first and second seed layers 401, 402 are oriented with the respective Si-terminated surfaces facing each other.

Alternatively, in case of a configuration where the multilayer seed should have a Si-terminated growth surface, the uppermost seed layer and the lower, adjacent layer should be turned with the respective C-faces towards each other so as to compensate the respective internal stresses.

The individual seed layers that compose a multilayer seed may have the same or similar layer thicknesses, as the first and second seed layers 401, 402 of the multilayer seed 400.

Alternatively, a multilayer seed may be composed of seed layers with different thickness, as in the configuration of a multilayer seed 500 shown in Fig. 5. The multilayer seed 500 comprises a combination of two monocrystalline SiC seed layers of different thicknesses, i.e. a first seed layer 501 and a thinner, second seed layer 502. Similarly to the configuration described with reference to Fig. 4, the first and second seed layers 501, 502 are also firmly bonded together by a temperature-stable bonding layer 520, which may be made by gluing or sintering, such as the bonding layer 420 described above. The first seed layer 501 may be also fixed to the seed holder 112 by a fixation layer 530 made by gluing or sintering, e.g. using the same compounds used for the bonding layer 520, or by clamping.

Similarly to the configuration described with reference to Fig. 4, the growth surface 540 of the multilayer seed 500 preferably corresponds to the C-face of the uppermost, second seed layer 502. The first seed layer 501 is then oriented based on its intrinsic stress 511 so as to counter-act the effect from the intrinsic stress region 512 carried by the second seed layer 502 at the growth temperatures. In order to achieve the desired equalization of internal stresses at the uppermost growth layer 502 of the multilayer seed 500, the thickness and level of intrinsic stress among the individual seed layers 501, 502 are parameters to take into consideration when selecting the seed layers 501, 502 that form the multilayer seed 500. For instance, the smaller thickness of the uppermost seed layer 502 may imply that it carries less intrinsic stress regions than the thicker seed layer 501, namely, if made from the same bulk SIC single-crystal, but may be more prone to thermally-induced deformations in the growth temperature range due to its reduce thickness. The optimal parameters can be found based on a characterization of the thermally induced deformations of a single seed layer in function of its thickness, for e.g. by way of experimentation or by simulation methods.

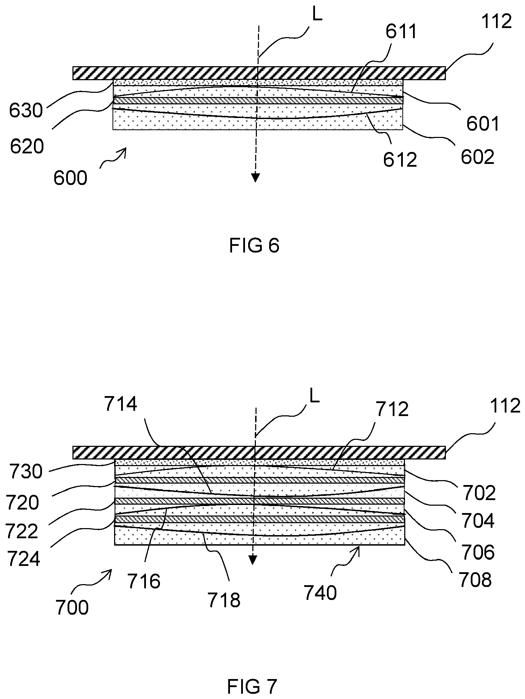

Fig. 6 shows a further configuration of a multilayer seed 600 comprising a combination of two monocrystalline SiC seed layers of different thicknesses, a first seed layer 601 and a second seed layer 602. The multilayer seed 600 differs from the configuration of Fig. 5 in that the free, uppermost seed layer 602 has a larger thickness in the mid-axis direction L than the underlying seed layer 601.

Similarly to the configuration described with reference to Fig. 5, the first and second seed layers 601, 602 carry respective internal stress regions 611, 612, and are firmly bonded to each other by a bonding layer 620. Further, the multilayer seed 600 is fixed to the seed holder 112 by a fixation layer 630. Both the bonding layer 620 and the fixation layer 630 may have properties similar to the connections layer 520 and 530 described above, respectively. The growth surface of the multilayer seed 600 preferably corresponds to the C-face of the uppermost seed layer 602 for growing a 4H-SiC single-crystal. As a result, in order to counter-act the effect from the intrinsic stress region 612 carried by the uppermost seed layer 602 at the growth temperature, the lower seed layer 601 is oriented with its Si-face turned towards the Si-face of the uppermost seed layer 602 (i.e. with an upward curvature of its stress region 611 in the direction of the mid-axis L and facing a downward curvature of the stress region 612).

The desired equalization of internal stresses may be achieved by setting a balance between thickness and intrinsic stress strength of the individual seed layers 601, 602. As explained above, the uppermost seed layer 602 may carry more intrinsic stress regions than the first seed layer 601 but may be less prone to thermally induced deformations at the growth temperature ranges due to its larger thickness. As mentioned above, the optimal parameters can be determined based on a characterization of the single seed layers in function of its thickness, for e.g. by way of experimentation or by simulation methods.

The multilayer seed according to the present invention may be composed by more than two monocrystalline seed layers, preferably less than four. In addition, it may be advantageous to design a multilayer seed with a pair number of seed layers as this facilitates the equalization of the overall internal stresses by selecting pairs of adjacent seed layers that effectively counter-act the internal stresses of each other.

For instance, Fig. 7 shows a configuration of a multilayer seed 700 comprising four monocrystalline SiC seed layers 702, 704, 706 and 708. Similarly to the previous embodiments, the first to fourth seed layers 702, 704, 706 and 708 are arranged adjacent to each other along a mid-axis L in a stacked manner. Each of the first to fourth seed layers 702, 704, 706 and 708 carries respective internal stress regions 712, 714, 716 and 718, and is firmly bonded to an adjacent, neighbor seed layer by respective connections layers 720, 722 and 724. The multilayer seed 700 may be fixed to the seed holder 112 by a fixation layer 730 or by clamping. Both the bonding layers 720, 722 and 724 and the fixation layer 730 have properties similar to the connections layer 420 and 530 described above, respectively.

Similarly to the configuration described with reference to Figs. 5 - 6, the growth surface of the multilayer seed 700 preferably corresponds to the C-face of the uppermost seed layer 708 for growing a 4H-SiC single-crystal. The underlying first to third seed layers 702, 704, 706 are oriented with respect to the immediately adjacent seed layers so as to counter-act the effect from the intrinsic stress region 718 carried by the at least one of the immediately adjacent seed layer, i.e. by alternating the direction of the curvature of the intrinsic stress regions along the stack of multilayers in the direction of the mid-axis L. Accordingly, the top seed layer 708 has its Si-face turned towards the directly adjacent seed layer 706, which is turned with its Si-face towards the top seed layer 708. Consequently, the C-face of the intermediate, third seed layer 706 is turned towards the C-face of the intermediate, second seed layer 704. The adjacent first and second seed layers 702, 704 for a lower pair of seed layers which are oriented with the respective Si-faces turned towards each other.

The plurality of seed layers forming the multilayer seed are thus oriented along the mid-axis L such that any of two directly adjacent seed layers are oriented to face each other with the same type of terminated surface (i.e. either the Si-faces or the C-faces). This applies not only to the case where the terminating, growth surface of the multilayer seeds corresponds to the carbon-terminated surface of the uppermost, monocrystalline seed layer, for growing pure 4H-SiC single-crystals, but also to multilayer seeds designed for growing other types of single-crystals, and which may terminated by other crystalline surfaces, e.g. the Si-terminated surface.

In order to achieve a multilayer seed with an unstressed uppermost surface for growing stress-free single-crystals thereon, the monocrystalline seed layers are selected according to one or more parameters related with the strength of the intrinsic stress carried by each individual, monocrystalline seed layer so that the respective internal stresses can be equalized, at least at the growth temperature ranges, as it will be described in the following.

For instance, any or a combination of geometry parameters typically used to characterize the flatness of semiconductor substrates, such as bow, warp and the total thickness variation (TTV), but more particularly by bow measurements, may be used to quantify the strength of the intrinsic, internal stresses carried by a monocrystalline seed layer.

According to the standard definitions used in the production of silicon substrates, the bow value indicates the deviation of the center point of the median surface of a free, unclamped substrate from the median surface reference plane established by three points equally spaced on a circle, e.g. a three-point plane defined around the edge of the substrate. The median surface may be defined as the locus of points in the substrate that are equidistant between the front and back surfaces. Bow value can be negative or positive depending on whether the center point is below or above the reference plane. Warp is the difference between the maximum and minimum distances of the median surface from the reference plane by taking into account the entire median surface of the substrate rather than only the center point as in bow measurements. The TTV value gives the difference between the maximum and minimum thicknesses of the substrate.

It is known that the internal stress in a monocrystalline SiC wafer is proportional to its bow value over wide temperature ranges, so that a bow measurement can be used as a measured variable to determine the intrinsic stress of a SiC seed layer even at elevated temperatures. The effectiveness of the stress reduction achieved by the combination of seed layers forming a particular multilayer seed may then be checked by bow measurements of the individual seed layers and/or of the resulting multilayer seed itself. Namely, by setting a maximum degree of bow of a multilayer seed at room temperature, e.g. a maximum bow of 50 µm in module (i.e. measured bow values should lie between - 50 µm and + 50 µm), it can be assumed that the intrinsic stresses in a multilayer seed are negligible at the typical growth temperatures, when the measured bow is below this maximum limit.

Additional or alternative methods for quantifying the degree of intrinsic, internal stress carried by the seed layers include measurements of the lattice planes bending or the convexity of the bulk single-crystal from which the seed layers are prepared.

In addition, it is advantageous to be able to control and/or adjust one or more parameters that have influence on the internal stress carried by each monocrystalline seed.

For instance, a monocrystalline seed may carry internal stresses which are not only those thermally induced during crystal growth, but also mechanical stresses introduced into the grown single-crystal (or the wafers prepared from it) by the subsequent processing of the grown crystal, the so-called sub-surface damage. Sub-surface damage generates stresses due to the disturbances of the crystal lattice near the surface caused by the mechanical processes (e.g. wire sawing and grinding) applied to the bulk single-crystals and usually can be removed by finer forms of processing, such as polishing. The degree of sub-surface damage thus provides an adjustable parameter for controlling the mechanical internal stress carried by a monocrystalline seed layer, and therefore, the overall intrinsic stress. For instance, as a rule it is preferable that the uppermost seed layer (i.e. the growth seed layer) in a multilayer seed does not exhibit any sub-surface damage, as this may have a negative effect on the quality of the single-crystal to be subsequently grown onto the multilayer seed. On the other hand, the lower seed layers may have a defined sub-surface damage and thus a defined induced mechanical stress, so that mechanically and thermally induced stresses in neighboring seed layers, especially in the uppermost seed layer of the multilayer seed, can be compensated via this additional, adjustable parameter of the individual seed layers. Thus, the sub-surface damage provides an additional parameter which can be consciously controlled and individually adjusted to influence the tensions carried by each of the seed layers that form the multilayer seed.

A further parameter that may be used to influence the thermally-induced stress of a seed layer is the degree of doping. For instance, during growth of SiC single-crystals, it is common to introduce a doping element, such as nitrogen, into the PVT growth reactor in a controlled admixture with an inert gas, e.g. argon. The inclusion of nitrogen into the crystal lattice of the SiC single-crystal influences the electrical properties, e.g. resistance, of the SiC substrates made from the doped SiC single-crystal. Moreover, the degree of nitrogen content in the crystal lattice also changes the brittleness of silicon carbide and thus the effects of thermally-induced stress on the geometry parameters of the SiC substrates prepared from the doped SiC single-crystal.

Thus, the multilayer seed may be composed of one or more seed layers produced from SiC single-crystals with a given doping content at which a desired strength of thermally-induced stress of the individual seed layers is achieved. The optimal doping content will depend on the specific characteristics of the multilayer seed (e.g. semiconductor material, number of seed layers, seed layer thickness, and the like) and may be determined for a given design of multilayer seed by experimental and/or simulation methods.

An additional or alternative parameter for achieving the desired equalization of internal stresses in a multilayer seed is the thickness (or relative thicknesses) of the seed layers composing the multilayer seed, as this parameter influences the overall effect of the internal stress carried by each individual seed layer. For instance, the thickness of a SiC multilayer seed in the direction of crystal growth can be up to 5 mm, whereby the uppermost SiC seed layer on which the single-crystal is to grow (i.e. the growth seed layer) should preferably have a thickness between 0.5 mm and 2 mm. Suitable thicknesses for the other individual SiC seed layers and/or for most multilayer seed designs are the range from 350 µm to 1 mm.

In any of the multilayer seed configurations described above, the uppermost seed layer for crystal growth may be a monocrystalline layer oriented with the [0001] crystalline axis tilted out of the longitudinal mid-axis (L) by a tilt angle between 0° and 8°, or between 2° and 6°. That is, the basal plane (0001) is tilted with respect to a plane parallel to the growth surface of the multilayer seed layer by the tilt angle. Such crystalline orientation of the seed layer upon which crystal growth will take place may be favorable to certain epitaxial processes. For instance, the commonly desired 4°off-axis SiC substrates have a 4° tilt of the basal plane (0001) in the [-1 -1 20] crystalline direction which allows to achieve an optimal step flow during epitaxy processes and thus, ensure an optimal quality of the deposited epitaxial films.

Although the present invention applies primarily to the reduction of the overall stress on a multilayer seed composed of monocrystalline seed layers, the seed holder itself may also contribute to the balance of internal stresses in the multilayer seed. The multilayer seed may thus be designed in such a way that additional occurring tensions can be compensated via the fixation with the seed holder, which is commonly made of graphite. In such a case, in order to take into account the effect of the seed holder, the geometry values of the multilayer seed including the seed holder should be also measured.

The multilayer seeds of the present invention may be composed of a combination of monocrystalline seed layers made of SiC and/or other semiconductor materials. For instance, the multilayer seed may be an homostructure of monocrystalline seed layers that share similar properties, e.g. semiconductor material, layer thickness, doping content, and the like. Alternatively, the multilayer seed may be formed as an heterostructure, in which all or only a few seed layers have different properties and/or are made from different semiconductors. The present invention is thus not limited to single-crystals and multilayer seeds made of SiC. Besides SiC, the multilayer seed may be made of other semiconductor materials, e.g. AIN and GaN (where homo- and heterostructures are possible) as well as e.g. also GaN, AIN, AlGaN, AllnN and InN as an heterostructure on sapphire, GaAs, Si or oxidic substrates.

The principles underlying the present invention for producing high-quality single-crystals can also be transferred to any systems based on the growth of semiconductor single-crystals by PVT processes (or similar sublimation processes) onto the surface of a seed, and particularly, in which the seed surface corresponds approximately to the diameter of the growing single-crystal. In particular, the present invention is suitable for growing bulk single-crystals with diameters suitable for producing substrates with diameters of approximately 150 mm, 200 mm and 300 mm can be produced. Accordingly, the individual seed layers forming the multilayer seed can have different diameters. In this respect, it should be noted that a bulk SiC single-crystal usually has a diameter that corresponds approximately to the target diameter of the SiC substrates to be produced from it. Nonetheless, the bulk SiC single-crystal diameter may also be up to 15% larger than the target diameter of the SiC substrates, i.e. approx. 150 mm, approx. 200 mm or approx. 300 mm.

Accordingly, the present invention also includes use of the multilayer seed on a sublimation process for growing a semiconductor single-crystal. In general, the diameter of the seed and/or multilayer seed corresponds approximately to the diameter of the single-crystal to be grown thereon. However, the seed diameter may be up to 15% smaller or larger than the diameter of the single-crystal to be grown, depending on the process and the setup used for growing the single-crystal.

The present invention also provides a method of producing the multilayer seed. The method comprises selecting at least two seed crystals for the at least two seed layers of the multilayer seed, arranging the at least two seed crystals adjacent to each other along an axial direction which is an intended direction for growing a single-crystal onto the multilayer seed, and forming a bonding layer between each pair of adjacent seed layers so as to firmly connected the multiple seed layers to each other. Each of the seed crystals is selected based on one or more of parameters associated with a respective degree of internal stress such as to counter-act the respective internal stresses from each other, and therefore, achieve a multilayer seed with a virtually stress-free growth surface. This selection may be made based on one or more of a bow value, a warp value, a total thickness variation value, a thickness, and a doping content of the respective seed layers and/or taking into consideration the desired characteristics for the multilayer seed, such as total thickness, type of semiconductor material(s) of the seed layers and single-crystal to be grown thereon, growth temperatures of the sublimation growth process, and the like. The parameters of the multiple seed layers that optimize the desired equalization of internal stresses may be found based on experimentation and/or simulation methods.

Furthermore, the multilayer seed of the present invention may be used in a wide range of sublimation processes for growing semiconductor single-crystals with the above-mentioned benefits of the present invention. In particular, the present invention envisages a physical vapor transport (PVT) method for producing at least one SiC single-crystal, comprising: arranging, inside a PVT growth crucible, at least one multilayer seed and a source material adapted to grow a SiC single-crystal; introducing the growth crucible into an inductively-heated or resistance-heated reactor of a PVT system; and controlling the temperature gradients established inside the growth crucible to grow the at least one SiC single-crystal onto the at least one seed, for e.g. to achieve a growth temperature range from 2000°C to 2500°C, or from 2100°C to 2400°C inside the PVT growth crucible.

The multi-layer seed according to the present invention may be advantageously used for both vertical and horizontal crystal growth processes, i.e. oriented with its longitudinal mid-axis L along the vertical direction for growing single-crystals in the gravity direction (or opposite to the gravity direction) or with the longitudinal mid-axis L aligned in the horizontal direction.

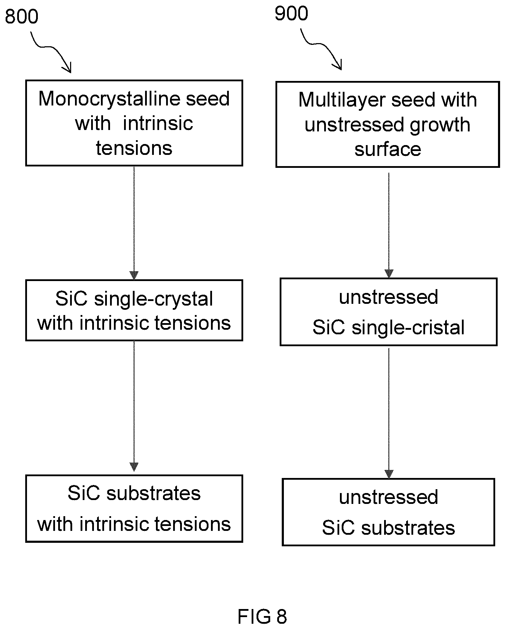

As illustrated in Fig. 8, the process 900 of using a multilayer seed according to the present invention makes possible to grow bulk single-crystals as if onto a virtually unstressed seed as opposed to a conventional process 800 that uses a single-layer monocrystalline seed. Thus, the present invention provides a new concept of multilayer seeds that eliminates a problem which is at the origin of the unexpected low quality of the SiC substrates produced from SiC single-crystals grown by sublimation processes.

In conclusion, the present invention provides a multilayer seed composed of a combination of monocrystalline seeds which makes possible to grow high-quality semiconductor single-crystals, such as SiC single-crystals, with reduced internal stress. This increases the quality of the grown semiconductor single-crystals and consequently, of the wafers produced from them. In particular, wafers having reduced internal thermal stresses and containing fewer dislocations, namely fewer stress-induced basal plane dislocations, can be produced.

Certain features of the above exemplary embodiments were described using the term "monocrystalline seed layer" (or simply "seed layer"). This term is to be understood as referring to a slice or wafer of a monocrystalline semiconductor of a thickness in the order of several µm or higher, and therefore, should not be construed as referring to a layer in the sense of a few atomic lattice planes. Further, the monocrystalline seed layers preferably have flat, disk-like surfaces in a direction transverse to a longitudinal mid-axis L of the multilayer seed, which corresponds to the intended direction for crystal growth.

Terms such as "uppermost" and "lower" were used with reference to the longitudinal mid-axis L for the purpose of facilitating the description of the respective features and their relative orientation within the multilayer seed only and should not be construed as limiting the use of the claimed invention or any of its components to a particular spatial orientation.

### Reference Numerals

| **Reference Numeral** | **Description** |
|---|---|
| 100 | growth arrangement |
| 102 | bulk single-crystal |
| 104 | monolayer, seed crystal |
| 106 | growth crucible |
| 108 | source material region |
| 110 | crystal growth region |
| 112 | seed holder |
| 114 | crucible lid |
| 116 | source material |
| 118 | thermal induction coil |
| 120 | heat flow direction |
| 122 | crucible wall |
| L | axial direction, longitudinal mid-axis |
| 200 | sic single-crystal |
| 202 | convex uppermost surface |
| 204, 206, 208, 210 | induced tensions |
| 300 | monocrystalline seed |
| 302 | carbon-terminated surface |
| 304 | silicon-terminated surface |
| 400, 500, 600, 700 | multilayer seed |
| 401, 501, 601 | first seed layer |
| 402, 502, 602 | second seed layer, growth seed layer |
| 702, 704, 706, 708 | first to fourth seed layers of multilayer seed 700 |
| 420, 520, 620, 720, 722, 724 | bonding layer between seed layers |
| 411, 412, 511, 512, 611, 612, 712, 714, 717, 718 | internal stress regions |
| 430, 530, 630, 730 | fixation layer between seed holder and multilayer seed |
| 440, 540, 740 | carbon-terminated surface, growth surface |

## Claims

1. A multilayer seed for growing a single-crystal, comprising
at least two seed layers (401, 402; 501, 502; 601, 602; 702, 704, 706, 708), wherein
each of the at least two seed layers (401, 402; 501, 502; 601, 602; 702, 704, 706, 708) is a monocrystalline layer **characterized by** one or more parameters associated with a respective degree of internal stress,
said one or more parameters are selected such that the at least two seed layers (401, 402; 501, 502; 601, 602; 702, 704, 706, 708) are adapted to counter-act the respective internal stresses from each other.

2. A multilayer seed according to claim 1, wherein
each of the at least two seed layers (401, 402; 501, 502; 601, 602; 702, 704, 706, 708) is a monocrystalline layer, and/or
said one or more parameters includes one or more of a bow value, a warp value, a total thickness variation value, a thickness, and a doping content of the respective seed layer.

3. A multilayer seed according to claim 1 or 2, wherein
the at least two seed layers (401, 402; 501, 502; 601, 602; 702, 704, 706, 708) includes an uppermost seed layer (402; 502; 602; 708) that provides a growth surface adapted to grow the single-crystal thereon; and
the at least two seed layers (401, 402; 501, 502; 601, 602; 702, 704, 706, 708) are arranged adjacent to each other along an axial direction (L).

4. A multilayer seed according to any one of claims 1 to 3, wherein
each of the at least two seed layers (401, 402; 501, 502; 601, 602; 702, 704, 706, 708) is a monocrystalline layer terminated by a face of a first type, which is **characterized by** a first crystalline lattice plane, and an opposed face of a second type, which is **characterized by** a second lattice plane, and
adjacent seed layers are arranged with the same face type turned towards each other so as to counter-act their respective internal stresses.

5. A multilayer seed according to claim 4, wherein
the at least two seed layers (401, 402; 501, 502; 601, 602; 702, 704, 706, 708) are SiC monocrystalline layers, the first type face is a C-face and the second type face is a Si-face, and
the uppermost seed layer (402; 502; 602; 708) of the at least two seed layers (401, 402; 501, 502; 601, 602; 702, 704, 706, 708) is arranged with a C-face as the terminating surface for crystal growth.

6. A multilayer seed according to any one of claims 1 to 5, wherein
the at least two seed layers (401, 402; 501, 502; 601, 602; 702, 704, 706, 708) are selected based on their respective bow values so as to compensate the intrinsic stress of the adjacent seed layers and so that
the multilayer seed (400; 500; 600; 700) is **characterized by** a bow value between - 50µm and +50µm, or between -30µm and +30µm, or between -20µm and +20µm.

7. A multilayer seed according to any one of claims 1 to 6, wherein
the at least two seed layers (401, 402; 501, 502; 601, 602; 702, 704, 706, 708) are selected based on their respective warp values so as to compensate the intrinsic stress of the adjacent seed layers and so that
the multilayer seed (400; 500; 600; 700) is **characterized by** a warp value smaller than 50µm, or smaller than 30µm, or smaller than 20µm.

8. A multilayer seed according to any one of claims 1 to 7, wherein
the at least two seed layers (401, 402; 501, 502; 601, 602; 702, 704, 706, 708) are selected based on their respective total thickness variation values so as to compensate the intrinsic stress of the adjacent seed layers and so that
the multilayer seed (400; 500; 600; 700) is **characterized by** a total thickness variation value smaller than 50µm, or smaller than 30µm, or smaller than 20µm.

9. A multilayer seed according to any one of claims 1 to 8, wherein
a growth seed layer (402; 502; 602; 708) of the at least two seed layers (401, 402; 501, 502; 601, 602; 702, 704, 706, 708) has a minimum thickness of 0.5 mm and a maximum thickness of 2.0 mm, and
the at least two seed layers (401, 402; 501, 502; 601, 602; 702, 704, 706, 708), other than the growth seed layer (402; 502; 602; 708), have respective thicknesses between 350µm and 3mm.

10. A multilayer seed according to any one of claims 1 to 9, wherein the at least two seed layers (401, 402; 501, 502; 601, 602; 702, 704, 706, 708) are comprised of:
a maximum of four monocrystalline seed layers (702, 704, 706, 708); and/or
one or more monocrystalline seed layers with different doping contents; and/or
one or more monocrystalline seed layers made of any of the semiconductor materials selected from Si, SiC, AIN, GaN, AlGaN, AllnN and InN; and/or
an homostructure of monocrystalline seed layers made of one of the semiconductor materials selected from Si, SiC, AIN, GaN, AlGaN, AllnN and InN; and/or
an heterostructure of monocrystalline seed layers in a combination of semiconductor materials selected from Si, SiC, AIN, GaN, AlGaN, AllnN and InN.

11. A multilayer seed according to any one of claims 1 to 10, wherein
the at least two seed layers (401, 402; 501, 502; 601, 602; 702, 704, 706, 708) include one or more monocrystalline seed layers having different levels of sub-surface damage which is obtained by processing the seed layers with at least one of sawing, grinding, and polishing; and/or
the at least two seed layers (401, 402; 501, 502; 601, 602; 702, 704, 706, 708) are bonded together with a bonding layer (420; 520; 620; 720, 722, 724) between each pair of adjacent seed layers, the bonding layer (420; 520; 620; 720, 722, 724) being formed by adhesive means or sintering.

12. A multilayer seed according to any one of claims 1 to 11, wherein
the uppermost seed layer (402; 502; 602; 708) for crystal growth is oriented with the [0001] crystalline axis tilted out of an axial direction (L) by a tilt angle which is between 0° and 8°, or between 2° and 6°.

13. A method of producing a multilayer seed (400; 500; 600; 700) according to any one of claims 1 to 12, the method comprising:
selecting at least two seed crystals for the at least two seed layers (401, 402; 501, 502; 601, 602; 702, 704, 706, 708) of the multilayer seed (400; 500; 600; 700);
arranging the at least two seed crystals adjacent to each other along an axial direction (L) which is a direction for growing a single-crystal on the multilayer seed (400; 500; 600; 700); and
forming a bonding layer (420; 520; 620; 720, 722, 724) between each pair of adjacent seed layers;
wherein each of the at least two seed crystals is selected based on one or more parameters associated with a respective degree of internal stress such as to counter-act the respective internal stresses from each other.

14. Use of a multilayer seed (400; 500; 600; 700) according to any one of claims 1 to 12 on a sublimation process for growing a semiconductor single-crystal (102).

15. A PVT method for producing at least one SiC single-crystal, comprising:
arranging, inside a PVT growth crucible (106), at least one seed (400; 500; 600; 700) and a source material (116) adapted to grow a SiC single-crystal (102);
introducing the growth crucible (106) into an inductively-heated or resistance-heated reactor of a PVT system (100); and
controlling the temperature gradients established inside the growth crucible (106) to grow the at least one SiC single-crystal onto the at least one seed (400; 500; 600; 700);
**characterized in that**
the at least one seed is a multilayer seed (400; 500; 600; 700) according to any one of claims 1 to 12.

16. A process according to claim 15, wherein
the temperature gradients are controlled so as to achieve a growth temperature range from 2000°C to 2500°C, or from 2100°C to 2400°C inside the PVT growth crucible (106).
